# EUROPEAN PATENT APPLICATION

(11) **EP 1 713 020 A1**
(43) Date of publication of application: **18.10.2006**
(21) Application number: 05703363.1
(22) Date of filing: 07.01.2005
(51) Int. Cl.: G06K 19/00, H01L 21/50, H01L 21/60

(54) **METHOD OF FOR MANUFACTURING ELECTRONIC DEVICE**

(30) Priority: 15.01.2004 JP 2004008313
(71) Applicant: Hitachi Chemical Co., Ltd., Shinjuku-ku, Tokyo 163-0449 (JP)
(72) Inventor: TANAKA, Kousuke, x (JP); ISHIZAKA, Hironori, x (JP); TASAKI, Kouji, x (JP); SHIBUTANI, Masahito, x (JP); SHINZAWA, Masahisa, x (JP); TONOTSUKA, Hidehiko, x (JP); IWATA, Katsuya, x (JP)
(74) Representative: HOFFMANN EITLE
(86) International application number: PCT/JP2005/000095
(87) International publication number: WO 2005/069205

(57) **Abstract**

A method of manufacturing an electronic device comprising IC elements 10, on a set of opposite faces of which a first electrode 12 and a second electrode 13 are formed, a first circuit layer 20 where an antenna circuit 21 having a slit 1 is formed, and a second circuit layer 30 for electrically connecting the IC elements 10 and the antenna circuit 21. The IC elements 10 are placed individually in cutouts 74, into each of which one IC element 10 can be inserted, the cutouts being formed in the outer circumference of a disk-like carrier 70. Thus, with the method, an electronic device that is inexpensive and is manufactured with high productivity, and has improved communication characteristics is manufactured.

## Description

### Technical Field

The present invention relates to a manufacturing method for an electronic device like a noncontact type individual identification device providing IC elements, and more specifically a manufacturing method for manufacturing a device that furnishes excellent communication properties and that can be manufactured economically.

### Background Art

In recent years non-contact type individual identification systems that employee RFID (Radio Frequency Identification) tags have been focused on for use in systems for managing the entire lifecycle of a product, including all commercial aspects of manufacture of a product, its distribution and sales. Radio wave type RFID tags that use 2.45 GHz microwaves are noted for the structure that includes an external antenna attached to IC elements which enables communication to be performed over several meters. Presently, construction is ongoing of systems that operate for distribution of mass manufactured products as well as their product management and product history management.

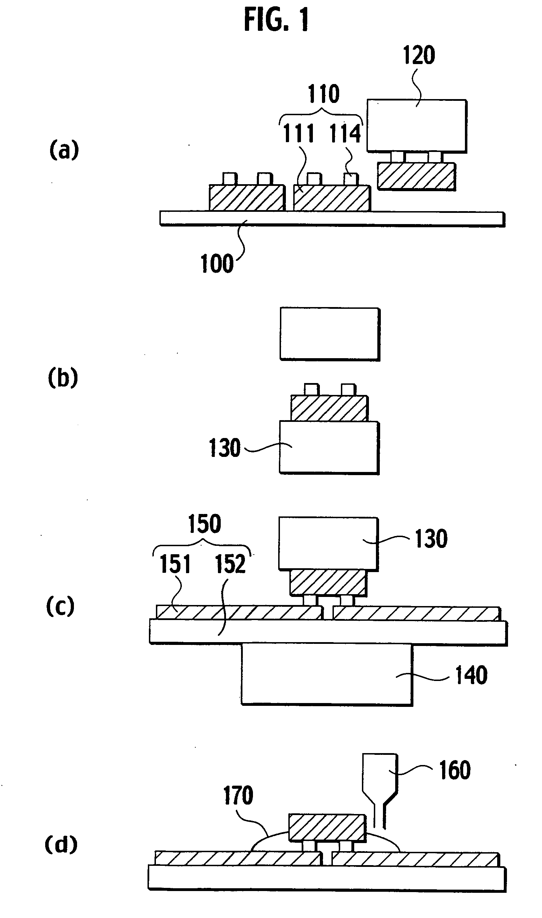

Current examples of radio wave type RFID tag systems using microwaves include products developed by Hitachi or Renesas that use a TCP (Tape Carrier Package) inlet. The manufacture of the TCP type inlet employs the TAB (Tape Automated Bonding) method in which IC elements having all external electrodes formed on the same surface thereof are mounted, each individually, on a tape carrier formed of a polyimide substrate with a succession of copper antenna circuits (Kouyama Susumu and Naruse Kunihiko "VLSI Packaging Technology", first and second volumes, Nikkei BP, 1993). RFID tag manufacturing processes employing a typical TAB method will now be described with reference to Fig. 1.

As shown in Fig. 1 (a), after IC elements 110 having a gold bump 114 formed on the circuit surface and in which all external electrodes are formed on the same face is separated into individual pieces by a dicing process, the individual pieces are sucked from a dicing film 100 using a vacuum suction unit 120. Next, as shown in Fig. 1 (b), the pieces are moved to a vacuum suction station 130 so that the gold bumps 114 of the IC elements 110 having all external electrodes formed on the same face thereof are made the upper face. Next, as shown in Fig. 1 (c) the vacuum suction station 130 is inverted such that the gold bumps 114 become the lower face. Next, the IC elements 110 having all of the external electrodes thereof formed on the same face are positioned in the determined position with respect to an antenna substrate 150, made by processing a polyimide base with copper film attached and manufacturing antenna circuits 151 on a base 152, and thereafter the IC elements 110 are secured in place by a thermal compression binding process using a heater 40. Connections can then be formed at the connecting parts of the gold bumps 114 on the antenna circuit 151 by a tin-gold alloy formed by applying a tin or solder plating thereto. As shown in Fig. 1 (d), the gaps occurring between the IC elements 110 having all external electrodes formed on the same face thereof and the antenna substrate 150 are sealed using a thermoset resin 600 supplied from a dispenser 160. The condition of this thermoset resin once the hardening process is complete is the intermediate condition of the RFID tag called an inlet. Accommodating this inlet in a label or thin case enables it to be used as an RFID tag.

Other inlet structures include for example having IC elements in which the external electrodes of the IC elements are formed individually on the respective surfaces of a pair of facing surfaces, as developed by Usami of Hitachi, having a glass diode package structure in which a dipole antenna connects to each external electrode formed on the respective surfaces (Japanese Unexamined Patent Application Publication No. 2002-269520). Further, in the device disclosed by Usami et al. when the IC elements in which the above described two external electrodes are formed individually on each of the surfaces of a pair of facing surfaces of the IC elements are furnished with an excitation slit type dipole antenna, the external electrodes formed individually on each of the surfaces of a pair of facing surfaces of the IC elements are disposed between the legs of an antenna to manufacture a sandwich antenna construction (ISSCC Digest of Technical Papers pages 398-399, 2003). In this dipole antenna structure having an excitation slit, the impedance of the antenna and input impedance of the IC elements can be made compatible by changing the width and length of the slit, thereby increasing the distance of achievable transmission.

### Disclosure of the Invention

In order to realize distribution and product management of a large number of products by a noncontact type individual identification system using RFID tags it is necessary to attach an RFID tag to each product, and this makes mass manufacturing of RFID tags cheaply indispensable.

However, in order to form a resonant circuit in which the two external electrodes of IC elements are connected to an antenna by spanning an excitation slit in an excitation type dipole antenna construction that provides favorable communication properties, it is necessary, in the case of IC elements in which all the external electrodes are formed on the same face, to achieve precise positioning of the two external electrodes for signal input and the slit. Therefore, in the TAB method shown in Fig. 1 of the conventional art, the steps involved include suction from the dicing film applied to IC elements having all external electrodes formed on the same face thereof and transportation using a vacuum suction device, or positionally aligning and arranging IC elements having all external electrodes formed on the same surface with an antenna substrate, and further, performing thermal compression binding of the IC elements having all external electrodes formed on the same face thereof to an antenna substrate before sealing with resin is performed for each individual IC elements. In these processes, it is extremely troublesome to make the available operating time for each step occur in one second or to reduce this below one second. This is a substantial problem affecting mass manufacture in this method and thus the TAB method has significant problems.

Further, if the available operating time is long then labor expenses increase concomitantly, mitigating against lower-cost manufacture, also as the connection between IC elements having all external electrodes formed on the same face thereof and an antenna substrate is realized using a gold-tin or gold solder connection, it is necessary to use as the substrate material, a taped substrate having copper film attached to polymide film that is expensive but strongly resistant to heat. This makes it very difficult to manufacture the inlet economically.

If the above described sandwich antenna construction is used, which encloses by an antenna each of the external electrodes formed individually on each of the faces of IC elements formed having two external electrodes each disposed individually on the respective faces that are a facing pair, the positioning between an excitation slit and each of the external electrodes formed individually on each of the faces of the IC elements must be extremely precise, and in the case of manufacturing methods of the conventional art that employs the TAB method, in order to reduce the available operating time, a method is used in which a plurality of the chips undergo suction and transportation using a plurality of vacuum suction devices. This creates problems however as complex manufacture equipment is required increasing equipment investment costs, and it is difficult to perform mass manufacture of the inlets and to achieve low costs.

In light of the above, the object of the present invention is to provide a manufacturing method for manufacturing an electronic device at low cost and with superior productivity where the device has satisfactory communication properties.

In order to solve the above described problems, the present invention provides a manufacturing method for an electronic device that has IC elements having an electrode formed on both faces thereof and a first and second circuit layer, this method being characterized by a step of electrically connecting the electrode of one side of the IC elements with the first circuit layer, electrically connecting the electrode of the other side of the IC elements with the second circuit layer and electrically connecting the first and second circuit layers, this method including a step of positionally aligning the connection surfaces of the IC elements and either one of the circuit layers while continuously supplying the IC elements and either one of the circuit layers separately.

It is preferable in this manufacturing method for the electronic device that the step of continuously supplying the IC elements includes a step of individually holding an IC element in an IC element holding part of an IC elements transport mechanism having not less than one IC element holding part; and a step of delivering the IC element thus held by running the transport part of the transport mechanism.

It is preferable in this manufacturing method for the electronic device that the IC elements transport mechanism is disc shaped.

It is preferable in this manufacturing method for the electronic device that the IC element holding part be formed as a notch shape.

It is preferable in this manufacturing method for the electronic device that the step of holding the IC elements individually in the IC element holding part of the transport mechanism uses an IC elements alignment/supply mechanism to facilitate holding of an individual IC element by the IC element holding part.

It is preferable in this manufacturing method for the electronic device that the IC elements alignment/supply mechanism be a linear feeder.

It is preferable in this manufacturing method for the electronic device that the IC elements alignment/supply mechanism be a high frequency alignment type feeder.

It is preferable in this manufacturing method for the electronic device, that the electrical connection of an electrode of the IC elements and at least one of the first or the second circuit layers be made via an anisotropic conductive adhesive layer.

It is preferable in this manufacturing method for the electronic device, that the after the step of positionally aligning the connection surfaces, there is a step of connecting at once, an electrode of the IC elements and at least one layer from among the first or the second circuit layers.

It is preferable in this manufacturing method for the electronic device, that the method by which the electrodes of the IC elements and at least one layer from among the first or the second circuit layers be connected at once is realized by thermal compression.

It is preferable in this manufacturing method for the electronic device, that the gaps between the first and second circuit layers be sealed by the thermal compression.

It is preferable in this manufacturing method for the electronic device, that after a step of connecting, at once, a plurality of the IC elements with at least one from among the first or the second circuit layers, there is a step of cutting a continuum of the plurality of the IC elements into individual pieces.

It is preferable in this manufacturing method for the electronic device, that a conductive layer be formed on the surface of at least one from among the first or the second circuit layers.

It is preferable in this manufacturing method for the electronic device, that at least one from among the first or the second circuit layers is provided with a slit.

It is preferable in this manufacturing method for the electronic device that the conductive layer includes aluminum.

It is preferable in this manufacturing method for the electronic device that at least one of the first and second metallic films be supported on a base substrate comprised of an organic resin, and that this organic resin be selected from among polyvinyl chloride (PVC), acrylonitrile butadiene styrene (ABS), polyethylene terephthalate (PET), polyethylene terephthalate glycol (PETG), polyethylene naphthalate (PEN), polycarbonate resin (PC), biaxial polyester (O-PET), or polymide resin.

It is preferable in this manufacturing method for the electronic device that either one of the first or the second metallic films is supported on a base substrate comprised of paper.

The manufacturing method for an electronic device furnishes the following effects. As IC elements having an external electrode formed respectively on each of the faces of an opposing pair are accommodated individually in a plurality of notches capable of accommodating the insertion of one of the IC elements that are arranged circumferentially around the outside of a disc shaped transport mechanism, when the disc shaped transport mechanism is rotated, a plurality of the IC elements up to a maximum number equivalent to the number of the notches, can be simultaneously delivered, thus, even when the IC elements are arranged individually on the first and second circuit layers, superior productivity can be realized and an inlet can be manufactured at a lower cost.

### Brief Description of the Drawings

Fig. 1 depicts the conventional manufacturing method;
Fig. 2 shows the structure of an inlet obtained using the manufacturing method according to the present invention;
Fig. 3 shows the manufacturing process steps relating to a first embodiment of the present invention; and
Fig. 4 shows the manufacturing process steps relating to a second embodiment of the present invention.

### Best Mode for Carrying out the Invention

The embodiments of the invention will now be described with reference to the drawings.

The electronic device of the present invention provides IC elements having an electrode formed on both surfaces, a first circuit layer, and a second circuit layer that operates as a bridging plate (connection cover) that electrically connects the IC elements and the first circuit layer.

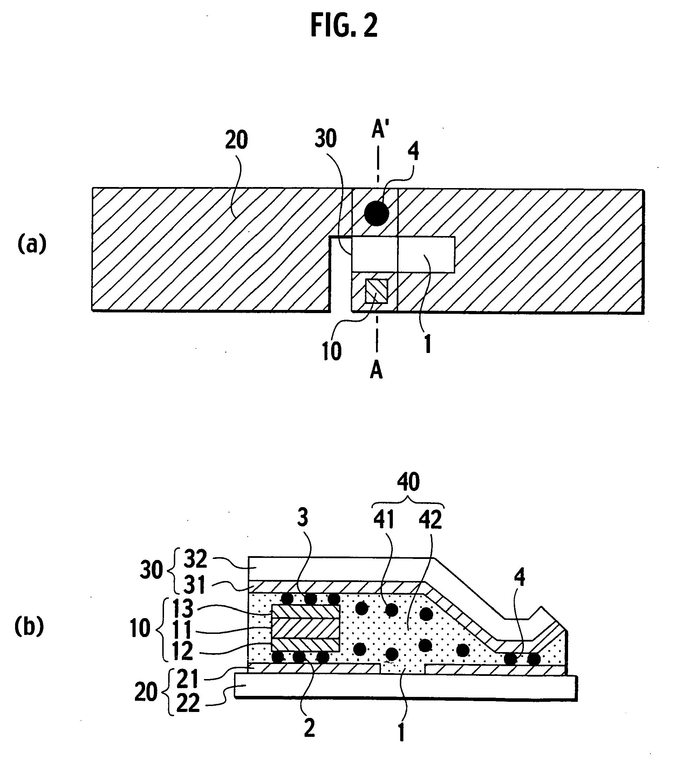

This electronic device is an inlet for an RFID tag that is made using the manufacturing method of the present invention. Fig. 2 (a) provides a schematic view from above of the inlet for an RFID tag. Fig. 2 (b) is a cross-sectional schematic view of the part A-A' in Fig. 2 (a). A simple description of the structure of the inlet will now be provided using Fig. 2.

As shown in Fig. 2 (b), the electrode 12 of one side and the electrode 13 of the other side are formed respectively on the respective surfaces of a pair of facing faces of the IC element 10. The IC element 10 is connected to a first circuit layer 20 comprised of a base a substrate 22 and an antenna circuit 21 by the electrode 12 in a first connecting part 2 via conductive particles 41 contained in an anisotropic conductive adhesive layer 40. In the same manner, in a second connecting part 3 the other electrode 13 of the IC element 10 is connected to a second circuit layer 30 comprised of a metallic film 31 and a base substrate 32, while in a third connecting part 4, the second circuit layer 30 is connected to the first circuit layer 20, each of these connecting parts connecting respectively via the conductive particles 41 contained in the anisotropic conductive adhesive layer 40. The second connecting part 3 of the other electrode 13 of the IC element 10 and the third connecting part 4 on the first circuit layer 20 are connected spanning a slit formed in the antenna circuit 21. That is to say, the electrode 12 and the other electrode 13 of the IC element 10 are electrically connected via the first connecting part 2, the antenna circuit 21, the third connecting part 4, the metallic film 31 of the second circuit layer 30 and the second connecting part 3. Further, the gaps between the first circuit layer 20 and the second circuit layer 30 are sealed by the matrix resin 42 of an anisotropic conductive adhesive layer 40.

An example of the method of manufacture for this electronic device will now be described with reference to the drawings.

The first example of a manufacturing method for the electronic device according to the present invention is a manufacturing method for an electronic device providing IC elements having an external electrode formed respectively on each of the faces of an opposing pair, a first circuit layer, having a slit formed therein, that operates as a transmission and reception antenna and a second circuit layer that electrically connects the IC elements and the first circuit layer, having at least a step of forming a plurality of antenna circuits using a first metallic film and forming the first circuit layer by disposing the antenna circuits on a base substrate, or a step of forming the first circuit layer by providing a plurality of antenna circuits from the first metallic film disposed on a base substrate; a step of it arranging a plurality of the IC elements; a step of accommodating the IC elements thus arranged individually in a plurality of notches capable of accommodating the insertion of one of the IC elements, these notches being arranged circumferentially around the outside of a disc shaped transport mechanism, and delivering the plurality of IC elements by the rotation of the disc shaped transport mechanism; a step of arranging via a first anisotropic conductive adhesive layer, the plurality of IC elements thus delivered on the second circuit layer forming a second metallic film, such that the plurality of delivered IC elements are electrically connected, thereby manufacturing a second circuit layer with IC elements attached; a step of positionally aligning the second circuit layer with IC elements attached in the determined position on the antenna circuits, such that the plurality of IC elements are electrically connected; and a step of thermal compression binding of the second circuit layer with IC elements attached in the determined position on the first circuit layer via the second anisotropic conductive adhesive layer.

The second example of a manufacture method for the electronic device according to the present invention is a manufacturing method for an electronic device providing IC elements having an external electrode formed respectively on each of the faces of an opposing pair, a first circuit layer, having a slit formed therein, that operates as a transmission and reception antenna and a second circuit layer that electrically connects the IC elements and the first circuit layer, having at least a step of forming a plurality of antenna circuits using a first metallic film and forming the first circuit layer by disposing the antenna circuits on a base substrate, or a step of forming the first circuit layer by providing a plurality of antenna circuits from the first metallic film disposed on a base substrate; a step of it arranging a plurality of the IC elements; a step of accommodating the IC elements thus arranged individually in a plurality of notches capable of accommodating the insertion of one of the IC elements, these notches being arranged circumferentially around the outside of a disc shaped transport mechanism, and delivering the plurality of IC elements by the rotation of the disc shaped transport mechanism; a step of positionally aligning each individually, the plurality of IC elements thus delivered, then arranging the IC elements via a first anisotropic conductive adhesive layer, such that these IC elements are electrically connected in their respective determined positions on the antenna circuits; a step of positionally aligning the IC elements thus arranged with the second circuit layer forming the second metallic film such that the IC elements are electrically connected in the determined position on the antenna circuit; and a step of thermal compression binding of the second circuit layer at once on the plurality of IC elements and the first circuit layer, via the second anisotropic conductive adhesive layer.

The third example of a manufacturing method for the electronic device according to the present invention is a manufacturing method for an electronic device providing IC elements having an external electrode formed respectively on each of the faces of an opposing pair, a first circuit layer, having a slit formed therein, that operates as a transmission and reception antenna and a second circuit layer that electrically connects the IC elements and the first circuit layer, having at least a step of forming a plurality of antenna circuits using a first metallic film and forming the first circuit layer by disposing the antenna circuits on a base substrate, or a step of forming the first circuit layer by providing a plurality of antenna circuits from the first metallic film disposed on a base substrate; a step of forming a first anisotropic conductive adhesive layer in the determined position on the antenna circuits; a step of arranging a plurality of the IC elements; a step of accommodating the IC elements thus arranged individually in a plurality of notches capable of accommodating the insertion of one of the IC elements, these notches being arranged circumferentially around the outside of a disc shaped transport mechanism, and delivering the plurality of IC elements by the rotation of the disc shaped transport mechanism; a step of positionally aligning each individually, the plurality of IC elements thus delivered, then arranging the IC elements via a first anisotropic conductive adhesive layer, such that these IC elements are electrically connected in their respective determined positions on the antenna circuits; a step of forming a second anisotropic conductive adhesive layer in the determined position on the antenna circuits and a plurality of the IC elements thus arranged; a step of positionally aligning the plurality of IC elements thus arranged with the second circuit layer forming the second metallic film such that the IC elements are electrically connected in the determined position on the antenna circuit; and a step of thermal compression binding of the second circuit layer at once on the plurality of IC elements and the first circuit layer.

In the first to third examples above, at least one of the first and second metallic films are aluminum.

In the first to third examples above, at least one of the first and second metallic films is supported on an organic resin or a base substrate comprised of paper. This organic resin may be selected from polyvinyl chloride (PVC), acrylonitrile butadiene styrene (ABS), polyethylene terephthalate (PET), polyethylene terephthalate glycol (PETG), polyethylene naphthalate (PEN), polycarbonate resin (PC), biaxial polyester (O-PET), or polymide resin.

In the first to third examples above, the method for forming the first circuit layer involves for example, using a first metallic film and forming a plurality of antenna circuits, then disposing the plurality of antenna circuits on a base substrate to form a first circuit layer, or disposing a first metallic film over a base substrate, then forming a plurality of antenna circuits thereon by etching or the like, to form an first circuit layer.

The method for arranging the IC elements could involve for example, using a linear feeder, a high frequency parts feeder or a high-speed bulk feeder and arranging elements components such as chip condensers or chip resistors or the like in a line.

In the first to third examples above, a point of benefit is that when the method involves a step of dividing the second circuit layer such that one piece is equivalent to the number of the IC elements in a line arranged in the widthwise direction of the first circuit layer, that can be subject to thermal compression binding at once, line by line, a step of positionally aligning the second circuit layer in the determined position on an antenna circuit and a step of thermal compression binding at once together, the second circuit layer on the IC elements and the first circuit layer via an anisotropic conductive adhesive layer, then the available operating time can be reduced.

In the first to third examples above, an anisotropic conductive adhesive layer can be formed on the respective surfaces on which the external electrodes of IC elements attach, and semiconductor elements of a condition in which IC elements are enclosed between the anisotropic conductive adhesive layers can be used, in which case the inlet can be manufactured with greater efficiency.

In the first to third examples above, the thermal compression binding of the first and second anisotropic conductive adhesive layers thermally press seals the plurality of the IC elements with the first and second circuit layers at once, and seals the gaps between first and second circuit layers.

In this case, making the total thickness of the first and second anisotropic conductive adhesive layers not less than half the thickness of IC elements enables a sealing to be realized between the first and second circuit layers and provides a high degree of reliability.

Dividing the second circuit layer into a plurality of pieces prior to the thermal compression binding enables prevention of positional misalignment due to heat warp.

In the first to third examples above, an anisotropic conductive adhesive layer can be formed on the respective surfaces on which the external electrodes of IC elements attaches, while another second circuit layer can be disposed in advance on the surface of one of the anisotropic conductive adhesive layers of the semiconductor elements of the condition in which the IC elements has been enclosed between the anisotropic conductive adhesive layers, this enabling the inlet to be manufactured with still greater efficiency.

In the first to third examples above, a method for disposing a second metallic film for forming the second circuit layer on a base substrate involves for example, a method in which a second metallic film is simply adhered on the base substrate, and with no necessity of performing processes such as etching or the like for the second metallic film, the process is completed swiftly, enabling the available operating time to be reduced and thereby realizing lower costs.

In the first to third examples above, after the process in which the second circuit later is thermal compression bound at once together with the IC elements and on the first circuit layer via anisotropic conductive adhesive layers, a process is performed in which a continuum of antenna circuits is cut into individual pieces one by one.

In the first to third examples above, in the cutting process, when the line A-A' in Fig. 2 is taken as the widthwise direction, the second circuit layer must have length sufficient to span the slit and reach the IC elements, while having length substantially equivalent to the width of the antenna circuit is preferable for enhancing the overall external appearance of the inlet.

In the first to third examples above, an inlet structure that is the electronic device according to the present invention can be obtained by performing each of the above steps.

An advantageous point about this inlet is that when used in the form of an RFID tag, providing a cover sheet above and below the inlet protects the circuit and prevents short-circuiting.

In the first to third examples above, as the plurality of arranged IC elements are accommodated individually in a plurality of notches capable of accommodating the insertion of one of the IC elements arranged circumferentially around the outside of a disc shaped transport mechanism, when the disc shaped transport mechanism is rotated, a plurality of the IC elements up to a maximum number equivalent to the number of the notches, can be simultaneously delivered, thus, even when the delivered IC elements are arranged individually on the second circuit layer and the antenna circuits, superior productivity can be realized in comparison to the case where the IC elements are held by suction using a vacuum suction device or the like, and delivered and arranged one by one. As increased productivity is realized the available operating time per inlet is reduced.

In the first to third examples above, as the IC elements and second circuit layer are used and a connective structure is made spanning a slit, high precision positional alignment of the external electrode on that surface of the IC elements that is on the side in contact with the antenna circuit, with the excitation slit on the antenna circuit is not necessary. This reduces the costs associated with manufacture equipment and facilitates high-speed delivery of the IC elements.

In the first to third examples above, each of the electrical connections of the IC elements with the second circuit layer and of the first and second circuit layers are made via an anisotropic conductive adhesive layer. As the connections via this anisotropic conductive adhesive layer are obtained by contact between each of the external electrodes formed on the respective surfaces of the IC elements that are the contacted body and conductive particles included within the anisotropic conductive adhesive layer, it is not necessary to have a surface coating over the antenna circuits, and there is no necessity to use a highly heat resistant base substrate that can withstand bonding at temperatures of above 200°C in order to form a metallic connection. This makes it possible to use a cheap base material and antenna circuit, thereby enabling cost reductions.

As the above described electric connection is made via an anisotropic conductive adhesive layer, in contrast to the case of the conventional art in which for example it is necessary when making a connection by a gold-tin alloy or the like to use a highly heat resistant polymide as the base material for the first circuit layer base substrate, it is possible to use cheaper polyethylene terephthalate. Further, as it is not necessary to use tin plating on the surface over the antenna circuit at the connecting part, it is possible to use cheaper aluminum that does not form well with a tin or solder coating as the material for the antenna circuit. Accordingly, a first circuit layer made by forming an aluminum antenna circuit on a polyethylene terephthalate base substrate is a satisfactory member for the manufacture of an inlet for a cheap RFID tag.

In the first example above, the first anisotropic conductive adhesive layer can be formed in advance on the second circuit layer, or it can be formed on the side of the IC elements having the other electrode. Again, the second anisotropic conductive adhesive layer can be formed in advance on the first circuit later or it may be formed on the other electrode 12 side of the IC elements.

In the second example above the first anisotropic conductive adhesive layer can be formed in advance on the first circuit layer, or it can be formed on the other electrode 12 side of the IC elements. Again, the second anisotropic conductive adhesive layer can be formed in advance on the second circuit layer or it may be formed on the IC elements and antenna circuit.

The manufacturing method for an electronic device according to the present invention is a manufacturing method for an electronic device providing IC elements having an external electrode formed respectively on each of the faces of the opposing pair, a transmission and reception antenna having a slit formed therein and a second circuit layer that electrically connects the IC elements and the antenna, wherein transportation of the IC elements is performed by accommodating the IC elements individually in notches capable of accommodating the insertion of one of the IC elements, a plurality of which notches are arranged circumferentially around the outside of a disc shaped transport mechanism, then rotating the disc shaped transport mechanism such that a plurality of the IC elements up to a maximum number equivalent to the number of the notches can be simultaneously delivered.

In the description of the first to third examples above, as IC elements are accommodated individually in notches capable of accommodating the insertion of one of the IC elements, a plurality of which notches are arranged circumferentially around the outside of a disc shaped transport mechanism and the disc shaped transport mechanism is rotated such that a plurality of the IC elements up to a maximum number equivalent to the number of the notches can be simultaneously delivered, when the IC elements are arranged individually so as to be electrically connected with the first and second circuit layers a dramatic improvement in the productivity for manufacturing the inlet is realized.

### Embodiments

Exemplary embodiments of the present invention will now be described with reference to the drawings, provided it is understood that the invention is not limited thereby and the following description is illustrative rather than restrictive.

Fig. 2 (a) shows an embodiment of the present invention, providing a schematic view from above of an inlet for an RFID tag manufactured using the manufacturing method of the present invention. Fig. 2 (b) is a cross-sectional schematic view of the part A-A' in Fig. 2 (a). A simple description of the structure of the inlet will now be provided using Fig. 2.

As shown in Fig. 2 (b), an electrode 12 and another electrode 13 are formed respectively on the respective surfaces of the pair of facing faces of the IC element 10. The IC element 10 is connected to a first circuit layer 20 that operates as an antenna substrate and is comprised of a base substrate 22 and antenna circuit 21, by the electrode 12 in a first connecting part 2 via conductive particles 41 contained in an anisotropic conductive adhesive layer 40. In the same manner, in a second connecting part 3 the second circuit layer 30 that operates as a bridging plate and is comprised of a base substrate 32 and metallic film 31 and the other electrode 13 are connected, while in a third connecting part 4 the second circuit layer 30 is connected to the first circuit layer 20, each of these connecting parts connecting respectively via the conductive particles 41. That is to say, the second connecting part 3 of the other electrode 13 of the IC element 10 and the third connecting part 4 on the first circuit layer 20 are connected spanning a slit formed in the first circuit layer 20. The electrode 12 and the other electrode 13 of the IC element 10 are electrically connected via the first connecting part 2, the antenna circuit 21, the third connecting part 4, the metallic film 31 of the second circuit layer 30 and the second connecting part 3. Further, the gaps between the first circuit layer 20 and the second circuit layer 30 are sealed by a matrix resin 42, an anisotropic conductive adhesive layer 40.

### Embodiment 1

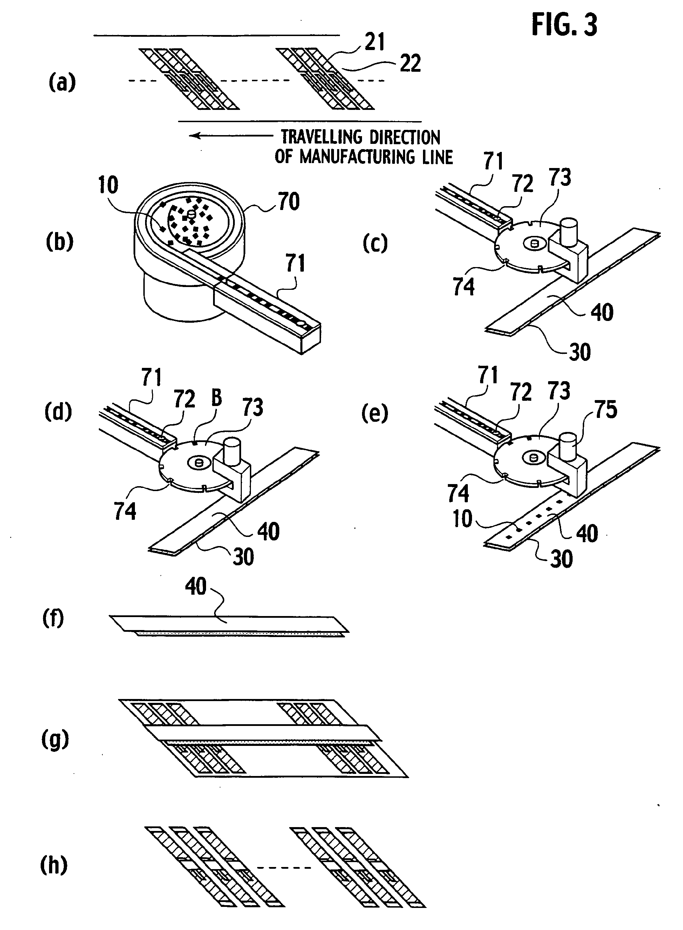

A first embodiment of the present invention will now be described with reference to Fig. 3.

As shown in Fig. 3 (a), an etching resist is formed by screen printing on an aluminum film surface of a tape form substrate manufactured by adhering aluminum film of a thickness of 9 µm to a polyethylene terephthalate substrate 22 of a thickness of 50 µm using an adhesive agent. Next, an antenna circuit 21 is formed continuously on the aluminum film surface using ferric chloride solution as an etching liquid. Here, the antenna thickness for each antenna circuit 21 is 2.5 mm, the thickness of the slit is 0.5 mm, and the antenna circuits 21 are formed at a pitch of 3 mm.

As shown in Fig. 3 (b), approximately 10000 IC elements 10 each having a thickness of 0.15 mm and a length and width both of 0.4 mm and having an external electrode formed respectively on the faces of each of the opposing pair of faces thereof are supplied to a high frequency parts feeder 70. The parts feeder 70 and a linear feeder 71 connected to the feeder 70 are made to vibrate at a frequency of 280 Hz such that the IC elements 10 are arranged in a line on the linear feeder 71.

Thereafter, as shown in Fig. 3 (c), an anisotropic conductive adhesive layer 40 is prepared on the aluminum film surface of a second circuit layer 30, which is formed by adhering aluminum film of a thickness of 9 µm using adhesive agent in place on a substrate of polyethylene terephthalate 32 that is 2 mm wide, 50 m long and 50 µm thick, by lamination at a temperature of 80°C of an anisotropic conductive adhesive film 2 mm wide and 50 m long (AC-2052P-45 by Hitachi Chemical), and then removing of the separator film. Then the linear feeder 71, the disc shaped transport mechanism 73 having a plurality of notches 74 each capable of accommodating a single IC element 10 and the anisotropic conductive adhesive layer 40 are arranged facing upwards. A pin 72 is provided at the tip of the linear feeder 71 for the purpose of preventing an IC element 10 becoming detached due to the vibrations and for separating the IC element 10 to be inserted in the notches 74 of the disc shaped transport mechanism 73 to obtain a single IC element 10.

Next, as shown in Fig. 3 (d), the pin 72 at the tip of the linear feeder 71 is lowered, the single IC element 10B only, arranged at the tip of the linear feeder 71, is inserted in a notch 74 of the disc shaped transport mechanism 73 and the disc shaped transport mechanism 73 is rotated. At this time, the pin 72 at the end of the linear feeder 71 rises in order to prevent detachment of the IC element 10 to be inserted, and the disc shaped transport mechanism 73 stops rotating at the position at which the notch 74 to be inserted with the next IC element 10 connects with the linear feeder 71.

Next, as shown in Fig. 3 (e), once the IC element 10B inserted in the notch 74 of the disc shaped transport mechanism 73 is positioned over the anisotropic conductive adhesive layer 40, the IC element 10B is removed from the notch 74 by a temporary securing pin 75 and secured on the anisotropic conductive adhesive layer 40 and the second circuit layer 30 having the anisotropic conductive adhesive layer 40 is moved 3 mm. This operation is repeated over and over until 40 of the IC elements 10 are disposed on the anisotropic conductive adhesive layer 40 formed on the second circuit layer 30 at intervals of 3 mm. At this time, there are 24 of the notches 74 arranged circumferentially on the disc shaped transport mechanism 73, the disc shaped transport mechanism 73 rotates at a speed of 25 rotations per second and the second circuit player 30 having the anisotropic conductive adhesive layer 40 moves at a speed of 18 mm per second.

Thereafter, as shown in Fig. 3 (f), the anisotropic conductive adhesive layer having the width as described is laminated at 80°C on the surface having the external electrode on that side opposite to the external electrode on the second circuit layer 30 side of the IC elements 10 thus arranged, and thereafter the separator film is removed to form the anisotropic conductive adhesive layer 40, making the second conductive adhesive layer 30 having attached thereon 40 IC elements 10 arranged in a line at a pitch of 3 mm. At this time, the respective surfaces of the IC elements 10 having the external electrodes attached are in a condition inserted between the anisotropic conductive adhesive layers 40.

Next, as shown in figure 3 (g), using a CCD camera and image processing device, the IC elements viewed from above the anisotropic conductive adhesive layer 40 of the second circuit layer 30 with the IC elements attached, are positionally aligned with respect to the determined position on the antenna circuits 21, and the IC elements 10 of the second circuit layer 30 with IC elements 10 attached are tentatively secured with the correct aspect for connection to the first circuit layer 20. Further, instead of using a CCD camera and image processing device, it should be no problem to position the IC elements with precision by visual observation from above the anisotropic conductive adhesive layer 40. Thereafter, a press applying head is lowered from the second adhesive layer 30 side, and the second circuit layer 30 with IC elements attached is thermally compression bound at once in the determined position with respect to one row of the antenna circuits 21 arranged in the widthwise direction of the first circuit layer 20 at a pressure of 3MPa, at 180°C with the heat being applied for 15 seconds, while the gaps between the first circuit layer 20 and the second circuit layer 30 are sealed. A protrusion having the thickness of the IC elements is formed in the determined position on the press applying head such that the connection of the IC elements and the first circuit layer 20 and second circuit layer 30 and the connection of the second circuit layer 30 with the first circuit layer 20 can be performed simultaneously.

Next, as shown in Fig. 3 (h) a press cutting machine is used to cut the arrangement into individual pieces thereby obtaining the inlet construction of the form as shown in Fig. 2.

By using the above described processes the time required for the transportation and arrangement of the IC elements is 0.167 seconds per inlet while the time required for connection of the second circuit layer 30 with IC elements 10 attached to the first circuit layer 20 is 0.375 seconds per inlet. Where a plurality of pressing heads are used the available operating time per inlet can be further reduced.

Further, the precision achieved in the position of the mounting of the IC elements 10 is kept within plus or minus sign 0.3 mm of the prescribed position and no detrimental effects in assembly or affecting transmission occur due to positional misalignment.

### Embodiment 2

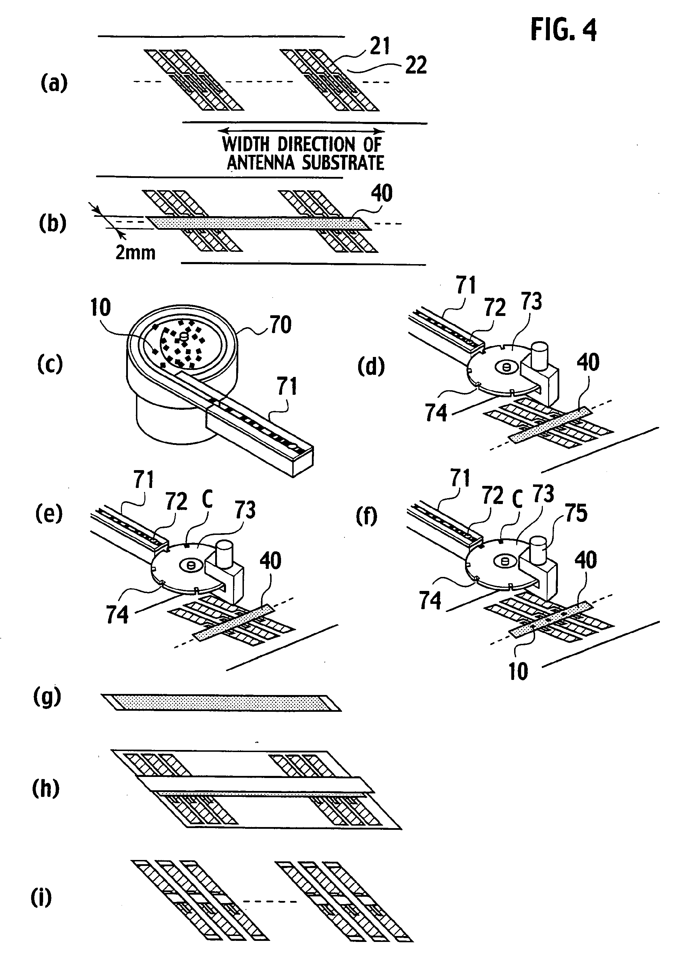

A second embodiment of the present invention will now be described with reference to Fig. 4.

As shown in Fig. 4 (a), an etching resist is formed by screen printing on an aluminum film surface of a tape form substrate manufactured by adhering aluminum film of a thickness of 9 µm to a polyethylene terephthalate substrate 22 of a thickness of 50 µm using an adhesive agent. Next, a continuum of antenna circuits 21 is formed on the aluminum film surface using ferric chloride solution as an etching liquid. Here, the antenna thickness for each antenna circuit is 2.5mm, the width of the slit is 0.5 mm, and the antenna circuits are formed at a pitch of 3 mm.

Next, as shown in Fig. 4 (b) an anisotropic conductive adhesive layer is formed in the determined position on the antenna circuits 21 by lamination at a temperature of 80°C of an anisotropic conductive adhesive film 40 (AC-2052P-45 by Hitachi Chemical) having a width of 2 mm, and then removal of the separator film.

Then, as shown in Fig. 4 (c), approximately 10000 IC elements 10 each having a thickness of 0.15 mm and a length and width both of 0.4 mm and having an external electrode formed respectively on the faces of each of the opposing pair of faces thereof are supplied to a high frequency parts feeder 70. The parts feeder 70 and a linear feeder 71 connected to the feeder 70 are made to vibrate at a frequency of 280 Hz such that the IC elements 10 are arranged in a line on the linear feeder 71.

Thereafter, as shown in Fig. 4 (d), the linear feeder 71, the disc shaped transport mechanism 73 having a plurality of notches 74 each capable of accommodating a single IC element 10 and the anisotropic conductive adhesive layer 40 formed in the determined position the on the antenna circuits 21 are arranged facing upwards. A pin 72 is provided at the tip of the linear feeder 71 for the purpose of preventing an IC element 10 becoming detached due to the vibrations and for separating the IC elements 10 to be inserted in the notches 74 of the disc shaped transport mechanism 73 to obtain a single IC element 10.

Next, as shown in Fig. 4 (e), the pin 72 at the tip of the linear feeder 71 is lowered, the single IC element 10C only, arranged at the tip of the linear feeder 71, is inserted in a notch 74 of the disc shaped transport mechanism 73 and the disc shaped transport mechanism 73 is rotated. At this time, the pin 72 at the end of the linear feeder 71 rises in order to prevent detachment of the IC element 10 to be inserted, and the disc shaped transport mechanism 73 stops rotating at the position at which the notch 74 to be inserted with the next IC elements 10 connects with the linear feeder 71.

Next, as shown in Fig. 4 (f), once the IC element 10C inserted in the notch 74 of the disc shaped transport mechanism 73 is positioned over the anisotropic conductive adhesive layer 40, the IC element 10C is removed from the notch 74 by a temporary securing pin 75 and secured on the anisotropic conductive adhesive layer 40 and the antenna circuits 21 having the anisotropic conductive adhesive layer 40 are moved 3 mm. This operation is repeated over and over until 40 of the IC elements 10 are disposed on the anisotropic conductive adhesive layer 40 formed on the antenna circuits 21 at intervals of 3 mm. At this time, there are 24 of the notches 74 arranged circumferentially on the disc shaped transport mechanism 73, the disc shaped transport mechanism 73 rotates at a speed of 25 rotations per second and the second circuit layer 30 having the anisotropic conductive adhesive layer 40 moves at a speed of 18 mm per second.

Thereafter, as shown in Fig. 4 (g), on the aluminum film surface of a tape form substrate having a width of 2 mm, which is formed by adhering aluminum film of a thickness of 9 µm using adhesive agent in place on a polyethylene terephthalate substrate 32 that is 50 µm thick, an anisotropic conductive adhesive layer 40 having the same width dimensions as that tape form substrate is applied by lamination at a temperature of 80°C. The separator film is then removed providing a second circuit layer 30 with anisotropic adhesive layer 40 attached.

Next, as shown in figure 4 (h), the second circuit layer 30 with anisotropic conductive adhesive layer 40 attached and the first circuit layer 20 are positionally aligned with their respective external dimensions matching and tentatively secured. Thereafter, a press applying head is lowered from that side of the arrangement having the second adhesive layer 30 with anisotropic conductive adhesive layer 40 attached, and the second circuit layer 30 with anisotropic conductive adhesive layer 40 attached is thermally compression bound at once in the determined position with respect to one row of the IC elements 10 and antenna circuits 21 arranged in the widthwise direction of the first circuit layer 20 at a pressure of 3MPa, at 180°C with the heat being applied for 15 seconds, while the gaps between the first circuit layer 20 and the second circuit layer 30 are sealed. A protrusion having the thickness of the IC elements is formed in the determined position on the press applying head such that the connection of the IC elements and the first circuit layer 20 and second circuit layer 30 and the connection of the second circuit layer 30 with the first circuit layer 20 can be performed simultaneously.

Next, as shown in Fig. 4 (i) a press cutting machine is used to cut the arrangement into individual pieces thereby obtaining the inlet construction of the form as shown in Fig. 2 and Fig. 3.

By using the above described processes, in the same manner as applies with respect to embodiment 1, the time required for the transportation and arrangement of the IC elements is 0.167 seconds per inlet while the time required for connection of the second circuit layer 30 to the first circuit layer 20 is 0.375 seconds per inlet. Where a plurality of pressing heads are used the available operating time per inlet can be further reduced.

Further, in the same manner as applies with respect to embodiment 1, the precision achieved in the position of the mounting of the IC elements 10 is kept within plus or minus sign 0.3 mm of the prescribed position and no detrimental effects in assembly or affecting transmission occur due to positional misalignment.

### Embodiment 3

The third embodiment will now be described.

The third embodiment is the same as the second embodiment up until the steps shown in figure 3 (f), wherein the processing of the first circuit layer 20 is performed, an anisotropic conductive adhesive layer 40 is formed by laminating the anisotropic conductive adhesive film on the antenna circuit 21, the IC elements having external electrodes formed on the respective surfaces of the opposing pair are arranged and delivered and the IC elements are individually arranged in the determined positions on the antenna circuit 21.

Then, an anisotropic conductive adhesive film having the same width as the above anisotropic conductive adhesive film is laminated at 80°C over those arranged IC elements, and the separator film is removed forming an anisotropic conductive adhesive layer 40.

Next, a tape form substrate 2 mm wide is prepared by adhering aluminum film of a thickness of 9 µm to a polyethylene terephthalate substrate 32 that is 50 µm thick using adhesive, making the second circuit layer 30. With that side of the second circuit layer 30 having the aluminum film surface facing the IC elements 10, the second circuit layer 30 is then positionally aligned and overlaid on the anisotropic diffusion layer film with the respective external dimensions matching and tentatively secured in place. Then, a press applying head is lowered from that side of the arrangement having the second adhesive layer 30 and the second circuit layer 30 is thermally compression bound at once in the determined position with respect to the IC elements 10 and antenna circuits 21 at a pressure of 3MPa, at 180°C with the heat being applied for 15 seconds, while the gaps between the first circuit layer 20 and the second circuit layer 30 are sealed. A protrusion having the thickness of the IC elements is formed in the determined position on the press applying head such that the connection of the IC elements and the first circuit layer 20 and second circuit layer 30 and the connection of the second circuit layer 30 with the first circuit layer 20 can be performed simultaneously.

Next, a press cutting machine is used to cut the arrangement into individual pieces thereby obtaining the inlet construction of the form as shown in Fig. 2 and Fig. 3.

By using the above described processes, in the same manner as applies with respect to embodiment 1 and embodiment 2, the time required for the transportation and arrangement of the IC elements is 0.167 seconds per inlet while the time required for connection of the second circuit layer 30 to the first circuit layer 20 is 0.375 seconds per inlet. Where a plurality of pressing heads are used the available operating time per inlet can be further reduced.

Further, in the same manner as applies with respect to embodiment 1 and embodiment 2, the precision achieved in the position of the mounting of the IC elements 10 is kept within plus or minus sign 0.3 mm of the prescribed position and no detrimental effects in assembly or affecting transmission occur due to positional misalignment.

### Embodiment 4

The fourth embodiment will now be described.

Firstly, an etching resist is formed by screen printing on an aluminum film surface of a tape form substrate manufactured by adhering aluminum film of a thickness of 9 µm to a polyethylene terephthalate substrate 22 of a thickness of 50 µm using an adhesive agent. Next, an antenna circuit 21 is formed continuously on the aluminum film surface using ferric chloride solution as an etching liquid. Here, the antenna thickness for each antenna circuit 21 is 2.5 mm, the thickness of the slit is 0.5 mm, and the antenna circuits 21 are formed at a pitch of 3 mm.

Next, an anisotropic conductive adhesive film 2 mm wide (AC-2052P-45 by Hitachi Chemical) is laminated in the determined position on the first circuit layer 20 at 80°C and the separator film is removed forming an anisotropic conductive adhesive layer 40.

Then, approximately 3000 IC elements 10 each having a thickness of 0.15 mm and a length and width both of 0.4 mm and having an external electrode formed respectively on the faces of each of the opposing pair of faces thereof are supplied to a high-speed bulk feeder. The IC elements 10 supplied from the high-speed bulk feeder, being arranged in a line, are delivered and arranged in the determined positions on the first circuit layer 20 by a high-speed chip mounter one by one.

Thereafter, on the aluminum film surface of a tape form substrate 2 mm wide, prepared by adhering aluminum film of a thickness of 9 µm to a polyethylene terephthalate substrate 32 that is 50 µm thick using adhesive, the anisotropic conductive adhesive layer having the same width dimensions as that aluminum film is laminated at 80°C, then the separator film is removed providing a second circuit layer 30 with anisotropic conductive adhesive layer 40 attached.

Next, the second circuit layer 30 with anisotropic conductive adhesive layer 40 attached and the first circuit layer 20 are positionally aligned with their external dimensions matching and tentatively secured in place. Then, a press applying head is lowered from that side of the arrangement having the second adhesive layer 30 with anisotropic conductive adhesive layer 40 attached, and the second circuit layer 30 with anisotropic conductive adhesive layer 40 attached is thermally compression bound at once in the determined position with respect to the IC elements 10 and antenna circuits 21 at a pressure of 3MPa, at 180°C with the heat being applied for 15 seconds, while the gaps between the first circuit layer 20 and the second circuit layer 30 and are sealed. A protrusion having the thickness of the IC elements is formed in the determined position on the press applying head such that the connection of the IC elements and the first circuit layer 20 and second circuit layer 30 and the connection of the second circuit layer 30 with the first circuit layer 20 can be performed simultaneously.

Next, a press cutting machine is used to cut the arrangement into individual pieces thereby obtaining the inlet construction of the form as shown in Fig. 2 and Fig. 3.

By using the above described processes, the time required for the transportation and arrangement of the IC elements is 0.2 seconds per inlet while the time required for connection of the second circuit layer 30 to the first circuit layer 20 is 0.375 seconds per inlet.

Further, in the same manner as applies with respect to embodiment 1 and embodiment 2, the precision achieved in the position of the mounting of the IC elements 10 is kept within plus or minus sign 0.3 mm of the prescribed position and no detrimental effects in assembly or affecting transmission occur due to positional misalignment.

A summary of the results of the above embodiments are shown in Table 1.

**Table 1**

| EMBODIMENT | TIME FOR TRANSPORTATION AND ARRANGEMENT (SECOND /PIECE) | TIME FOR CONNECTION (SECOND /PIECE) | DEFECTS IN ASSEMBLY (DEFECTS NO /TOTAL NO) | DEFECTS IN COMMUNICATION (DEFECTS NO /TOTAL NO) |
|---|---|---|---|---|
| FIRST EMBODIMENT | 0.167 | 0.375 | 0/2000 | 0/2000 |
| SECOND EMBODIMENT | 0.167 | 0.375 | 0/2000 | 0/2000 |
| THIRD EMBODIMENT | 0.0167 | 0.375 | 0/2000 | 0/2000 |

According to the above described embodiments of the present invention the available operating time for the manufacture of each inlet can be reduced to one second per inlet or less than one second per inlet thereby enabling cost reductions to be realized. Further, satisfactory communication properties are obtained and by using cheaper materials such as the anisotropic conductive adhesive and the like still further cost reductions are possible.

## Claims

1. A manufacturing method for an electronic device that has IC elements having an electrode formed on both faces thereof and a first and second circuit layer, comprising:
a step of electrically connecting the electrode of one side of the IC elements with the first circuit layer, electrically connecting the electrode of the other side of the IC elements with the second circuit layer and electrically connecting the first and second circuit layers; and
a step of positionally aligning the connection surfaces of the IC elements and either one of the circuit layers while continuously supplying the IC elements and either one of the circuit layers separately.

2. The manufacturing method for an electronic device according to claim 1 wherein the step of continuously supplying the IC elements comprises:
a step of individually holding an IC element in an IC element holding part of an IC elements transport mechanism having not less than one IC elements holding part; and
a step of delivering the IC element thus held by running the transport part of the transport mechanism.

3. The manufacturing method for an electronic device according to claim 2 wherein the IC elements transport mechanism is disc shaped.

4. The manufacturing method for an electronic device according to claim 2 wherein the IC element holding part is formed as a notch shape.

5. The manufacturing method for an electronic device according to claim 2 wherein the step of holding an IC element individually in the IC element holding part of the transport mechanism uses an IC elements alignment/supply mechanism to facilitate holding of an individual IC element by the IC element holding part.

6. The manufacturing method for an electronic device according to claim 5 wherein the IC elements alignment/supply mechanism is a linear feeder.

7. The manufacturing method for an electronic device according to claim 5 wherein the IC elements alignment/supply mechanism is a high frequency alignment type feeder.

8. The manufacturing method for an electronic device according to claim 1 wherein the electrical connection of an electrode of the IC elements and at least one of the first or the second circuit layers is made via an anisotropic conductive adhesive layer.

9. The manufacturing method for an electronic device according to claim 1, further comprising:
a step of connecting at once, the electrodes of the IC elements and at least one layer from among the first or the second circuit layers, wherein the step is after the step of positionally aligning the connection surfaces.

10. The manufacturing method for an electronic device according to claim 9 wherein the method in that the electrode of the IC elements and at least one layer from among the first or the second circuit layers is connected at once is realized by thermal compression.

11. The manufacturing method for an electronic device according to claim 10 wherein the gaps between the first and second circuit layers be sealed by the thermal compression.

12. The manufacturing method and electronic device according to claim 9, further comprising:
a step of cutting a continuum of the plurality of the IC elements into individual pieces, wherein the step is after the step of connecting, at once, a plurality of the IC elements with at least one from among the first or the second circuit layers.

13. The manufacturing method for an electronic device according to claim 1 wherein a conductive layer is formed on the surface of at least one from among the first or the second circuit layers.

14. The manufacturing method for an electronic device according to claim 1 wherein at least one from among the first or the second circuit layers is provided with a slit.

15. The manufacturing method for an electronic device according to claim 11 wherein the conductive layer includes aluminum.

16. The manufacturing method for an electronic device according to claim 11 wherein at least one from among the first and second metallic films is supported on a base substrate comprised of an organic resin, and that this organic resin be selected from among polyvinyl chloride (PVC), acrylonitrile butadiene styrene (ABS), polyethylene terephthalate (PET), polyethylene terephthalate glycol (PETG), polyethylene naphthalate (PEN), polycarbonate resin (PC), biaxial polyester (O-PET), or polymide resin.

17. The manufacturing method for an electronic device according to claim 11 wherein either one of the first or the second metallic films is supported on a base substrate comprised of paper.
